# EUROPÄISCHE PATENTSCHRIFT

(11) **EP 2 747 534 B1**
(45) Veröffentlichungstag und Bekanntmachung des Hinweises auf die Patenterteilung: **01.05.2019**
(21) Anmeldenummer: 13005568.4
(22) Anmeldetag: 29.11.2013
(51) Int. Cl.: H05K 7/20

(54) **Schaltschrank mit einer Anordnung zur Kühlung von in einem Innenraum des Schaltschranks aufgenommenen, Wärme abgebenden Komponenten**
Switchgear cabinet with an arrangement for cooling of the heat from components installed in the interior of the switchgear cabinet
Armoire de commande comprenant un agencement pour le refroidissement de composants émettant de la chaleur, logés dans un espace intérieur de l'armoire de commande

(30) Priorität: 18.12.2012 DE 102012112505
(43) Veröffentlichungstag der Anmeldung: 25.06.2014
(73) Patentinhaber: Rittal GmbH & Co. KG, 35745 Herborn (DE)
(72) Erfinder: Meyer, Andreas, 35460 Staufenberg (DE); Hartmann, Thomas, 35435 Krofdorf-Gleiberg (DE); Becker, Dieter, 35713 Eschenburg (DE)
(74) Vertreter: Angerhausen, Christoph

(56) Entgegenhaltungen:
- EP-A2- 2 461 661
- US-A1- 2009 225 513

## Beschreibung

Die Erfindung betrifft eine Anordnung aus einem Schaltschrank und einem Kühlgerät zur Kühlung von in einem Innenraum des Schaltschrankes aufgenommenen, Wärme abgebenden Komponenten, wobei die Anordnung aufweist: einen Lufteinlass für Umgebungsluft in den Schaltschrankinnenraum; einen Luftauslass für Warmluft aus dem Schaltschrankinnenraum an einer vertikalen Seite des Schaltschrankinnenraums, wobei der Luftauslass eine vertikale Abmessung aufweist, die zumindest einem Teil einer Höhe des Schaltschrankinnenraums entspricht; und einem Luft-Fluid-Wärmetauscher mit einem Kühlmittelkreislauf, wobei durch den Luft-Fluid-Wärmetauscher aus dem Schaltschrankinnenraum über den Luftauslass austretende Warmluft geführt ist, und wobei sich der Luft-Fluid-Wärmetauscher zumindest anteilig über die vertikale Abmessung des Luftauslasses erstreckt. Weiterhin ist eine Heatpipe-Vorrichtung mit mindestens einer sich zumindest über einen Teil der vertikalen Abmessung des Luftauslasses erstreckenden Heatpipe in Luftströmungsrichtung zwischen dem Luftauslass und dem Luft-Fluid-Wärmetauscher angeordnet. Ein derartiger Schaltschrank ist aus der EP 2 461 661 A2 bekannt.

Bei einem gattungsgemäßen Schaltschrank, wie er beispielsweise auch aus DE 10 2005 005 296 B3 bekannt ist, wird üblicherweise über eine vertikale Vorderseite des Schaltschrankes, welche beispielsweise als ein perforiertes Türelement ausgebildet sein kann, Umgebungsluft des Schaltschranks in den Schaltschrankinnenraum angesogen. Dazu können an der Schaltschrankvorderseite Ventilatoren angeordnet sein. Im Schaltschrankinnenraum wird die angesogene Luft im Wesentlichen horizontal an den in dem Schaltschrankinnenraum aufgenommenen Komponenten vorbei oder durch diese hindurch im Wesentlichen horizontal bis zu der der Schaltschrankvorderseite gegenüberliegenden vertikalen Schaltschrankrückseite durchgeleitet, um dort über einen Luftauslass für Warmluft durch einen an die vertikale Rückseite unmittelbar angrenzenden Luft-Fluid-Wärmetauscher geleitet zu werden. Nach dem Passieren des Luft-Fluid-Wärmetauschers wird die abgekühlte Luft wieder in die Umgebung des Schaltschrankes entlassen. Der Luft-Fluid-Wärmetauscher kann beispielsweise ein Verdampfer eines Verdichter getriebenen Kältemittelkreislaufes oder ein Luft-Wasser-Wärmeübertrager eines Kaltwasserkreislaufes sein.

Um eine gleichmäßige Anströmung der in dem Schaltschrankinnenraum aufgenommenen Komponenten zu erreichen, erstrecken sich bei dem gattungsgemäßen Schaltschrank üblicherweise sowohl der Lufteinlass als auch der Luftauslass über einen wesentlichen Teil der Höhe des Schaltschrankinnenraums, oder sogar über annähernd die gesamte Höhe des Schaltschrankinnenraums. Auch der Luft-Fluid-Wärmetauscher erstreckt sich vorzugsweise über einen wesentlichen Teil der Gesamthöhe des Schaltschrankinnenraums oder gar über annähernd die gesamte Höhe des Schaltschrankinnenraums. Dadurch wird erreicht, dass die Kühlluft über die gesamte Höhe des Schaltschrankinnenraums horizontal durch diesen hindurchgeleitet werden kann, so dass sämtliche Schaltschrankkomponenten optimal mit Kühlluft derselben Temperatur um oder durchströmt werden. Die in dem Schaltschrankinnenraum übereinander angeordneten Wärme abgebenden Komponenten weisen jedoch oftmals eine uneinheitliche Verlustabwärmeabgabe auf. Dies führt aufgrund des horizontalen Luftströmungsprofils dazu, dass sich an der vertikalen Seite des Schaltschrankinnenraums, an welche der Luft-Fluid-Wärmetauscher angrenzt, ein uneinheitliches Lufttemperatur-Profil ausbildet. Dementsprechend wird auch der Luft-Fluid-Wärmetauscher, über seine Gesamthöhe betrachtet, mit Luft unterschiedlicher Temperaturen angeströmt. Dies führt zur Ausbildung von Wärmenestern und beeinträchtigt damit die Wärmeübertragungsleistung des Luft-Fluid-Wärmetauschers. Dies hat zur Folge, dass die Effizienz der Kühlanordnung beeinträchtigt wird.

Es ist daher die Aufgabe der Erfindung, einen gattungsgemäßen Schaltschrank derart fortzuentwickeln, dass er auch für den Fall, dass in dem Schaltschrankinnenraum Komponenten mit sich stark unterscheidender Verlustabwärme aufgenommen sind, eine effiziente Kühlung des Schaltschrankinnenraums erlaubt.

Diese Aufgabe wird erfindungsgemäß durch die Schaltschrankanordnung mit den Merkmalen des Anspruchs 1 gelöst. Die abhängigen Ansprüche 2 bis 11 betreffen jeweils vorteilhafte Ausführungsformen der Erfindung.

Der erfindungsgemäße Schaltschrank zeichnet sich somit dadurch aus, dass sich die mindestens eine Heatpipe der Heatpipe-Vorrichtung und der Kühlmittelkreislauf des Luft-Fluid-Wärmetauschers durch eine Mehrzahl Lamellen hindurch erstrecken, sodass die Heatpipe-Vorrichtung über die Lamellen mit dem Luft-Fluid-Wärmetauscher thermisch gekoppelt ist, wobei zwischen benachbarten Lamellen ein Durchlass für die aus dem Luftauslass austretende Warmluft gebildet ist, wobei sich die Heatpipe-Vorrichtung und der Kühlmittelkreislauf des Luft-Fluid-Wärmetauscher zwischen einer lufteintretenden Seite und einer luftaustretenden Seite der Durchlässe erstrecken..

Die aus dem Luftauslass für Warmluft aus dem Schaltschrankinnenraum heraustretende Warmluft trifft somit zunächst, bevor sie durch den Luft-Fluid-Wärmetauscher hindurchtritt, auf die Heatpipe-Anordnung. Insbesondere an den Stellen, wo Luft mit relativ hoher Temperatur auf die Heatpipes trifft, verdampft das Kältemittel der Heatpipe und nimmt dabei Wärme auf. In dem Bereich der Heatpipe, wo weniger Wärme durch die elektrischen Komponenten auf die Kühlluft übertragen worden ist, ist die die Heatpipe anströmende Luft entsprechend kälter, so dass kein Kältemittel verdampft wird. Das zuvor in dem wärmeren Bereich verdampfte Kältemittel kann somit an Stellen, wo die Heatpipe mit Luft vergleichsweise geringerer Temperatur angeströmt wird, zumindest teilweise wieder kondensieren, wobei das Kältemittel über die Wand der Heatpipe und/oder angrenzende Lamellen Wärme an die die Heatpipe-Anordnung durchströmende (vergleichsweise kältere) Luft abgibt. Die Heatpipe-Anordnung hat somit gerade die Funktion, den Temperaturgradienten der Luft, mit welcher der Luft-Fluid-Wärmetauscher angeströmt wird, auszugleichen, oder zumindest zu verringern und damit die Ausbildung von Wärmenestern zu vermeiden. Dadurch, dass der Luft-Fluid-Wärmetauscher gleichmäßiger mit Wärme beaufschlagt wird, arbeitet er effektiver. Nach der Kondensation des Kältemittels läuft dieses als Flüssigkeit wieder in Richtung Warmbereich, um dort erneut zu verdampfen, so dass ein geschlossener Kreislauf entsteht.

Bei einer Ausführungsform der Erfindung ist der Luft-Fluid-Wärmetauscher um eine horizontale Abmessung der Heatpipe-Anordnung von der vertikalen Seite des Schaltschrankinnenraums beabstandet, so dass der Luft-Fluid-Wärmetauscher, anders als es beispielsweise bei der Anordnung gemäß der DE 10 2005 005 296 B3 gefordert ist, nicht die Rückseite des Schrankes abdeckend angeordnet ist. Dadurch wird gewährleistet, dass die über die vertikale Seite des Schaltschrankinnenraums austretende Warmluft zwangsläufig die Heatpipe-Anordnung passieren muss, um zu dem Luft-Fluid-Wärmetauscher zu gelangen.

Bei einer anderen Ausführungsform der Erfindung sind der Luft-Fluid-Wärmetauscher und die Heatpipe-Anordnung sich in vertikaler Richtung überlappend angeordnet, wobei die über den Luftauslass austretende Warmluft zumindest anteilig erst durch die Heatpipe-Anordnung und danach durch den Luft-Fluid-Wärmetauscher geführt ist. Vorzugsweise erstreckt sich bei dieser Ausführungsform die Heatpipe-Anordnung jedoch über die gesamte Höhe einer Lufteinlassseite des Luft-Fluid-Wärmetauschers.

Bei einer Ausführungsform der Erfindung ist die Heatpipe-Anordnung wie folgt ausgebildet:
a) mit einer ersten vertikalen Montageseite angrenzend an die vertikale Seite des Schaltschrankinnenraums und den Luftauslass anteilig oder vollständig überdeckend; und
b) mit einer zweiten, von der ersten Montageseite parallel beabstandeten vertikalen Montageseite, an welche der Luft-Fluid-Wärmetauscher angrenzt.

Bei dieser Ausführungsform sind die Heatpipe-Anordnung und der Luft-Fluid-Wärmetauscher somit als separate Bauteile ausgebildet, welche über die zweite Montageseite der Heatpipe-Anordnung miteinander verbunden sind.

Vorzugsweise sind die Heatpipe-Anordnung und der Luft-Fluid-Wärmetauscher als ein einheitliches Bauteil ausgebildet. Dabei kann vorgesehen sein, dass die mindestens eine Heatpipe der Heatpipe-Anordnung über eine Mehrzahl, vorzugsweise parallel zueinander und horizontal ausgerichteter, Lamellen mit dem Luft-Fluid-Wärmetauscher thermisch gekoppelt ist, wobei zwischen benachbarten Lamellen ein Durchlass für die aus dem Luftauslass austretende Warmluft gebildet ist.

Um die besonders einfache Montage der Kühlanordnung zu ermöglichen, ist bei einer Ausführungsform der Erfindung vorgesehen, dass der Schaltschrank ein Rahmengestell mit vertikalen und horizontalen, eine Systemlochung aufweisenden Profilstreben aufweist, wobei der Luftauslass von zwei vertikalen und zwei horizontalen, einen umlaufenden Rahmen bildenden Profilstreben abgegrenzt ist.

Um der den Schaltschrank durchströmenden Luft einen möglichst geringen Strömungswiderstrand entgegenzusetzen, ist bei einer Ausführungsform der Erfindung vorgesehen, dass die Heatpipe-Anordnung und der Luft-Fluid-Wärmetauscher ein Luftleitsystem aufweisen, so dass sie optimal von der Warmluft horizontal durchströmt sind.

Eine optimale Kühlung des Schaltschranks über seine gesamte Höhe wird bei einer Ausführungsform der Erfindung dadurch erreicht, dass sich der Luftauslass, die Heatpipe-Anordnung und der Luft-Fluid-Wärmetauscher im Wesentlichen über die gesamte Höhe des Schaltschrankinnenraums erstrecken.

Um bei der erfindungsgemäßen Kühlanordnung im Servicefall die Heatpipe-Anordnung und den Luft-Fluid-Wärmetauscher unabhängig voneinander erreichen zu können, ist bei einer Ausführungsform der Erfindung vorgesehen, dass die Heatpipe-Anordnung und der Luft-Fluid-Wärmetauscher in einem Türelement, über das der Schaltschrankinnenraum zugänglich ist, in horizontaler Richtung hintereinander aufgenommen sind, so dass im Servicefall die Heatpipe-Anordnung über eine in Schließstellung des Türelements dem Schaltschrank-innenraum zugewandte, erste Türblattseite zugänglich ist, und der Luft-Fluid-Wärmetauscher über eine in Schließstellung des Türelements eine Außenseite des Schaltschranks bildende, zweite Türblattseite zugänglich ist.

Weitere Einzelheiten der Erfindung werden anhand der nachstehenden Figuren erläutert. Dabei zeigt:
- Figur 1: eine schematische Seitenquerschnittsansicht eines erfindungsgemäßen Schaltschranks gemäß einer ersten Ausführungsform; und
- Figur 2: eine schematische Seitenquerschnittsansicht einer Einheit aus einer Heatpipe-Anordnung und einem Luft-Fluid-Wärmetauscher gemäß einer zweiten Ausführungsform der Erfindung.

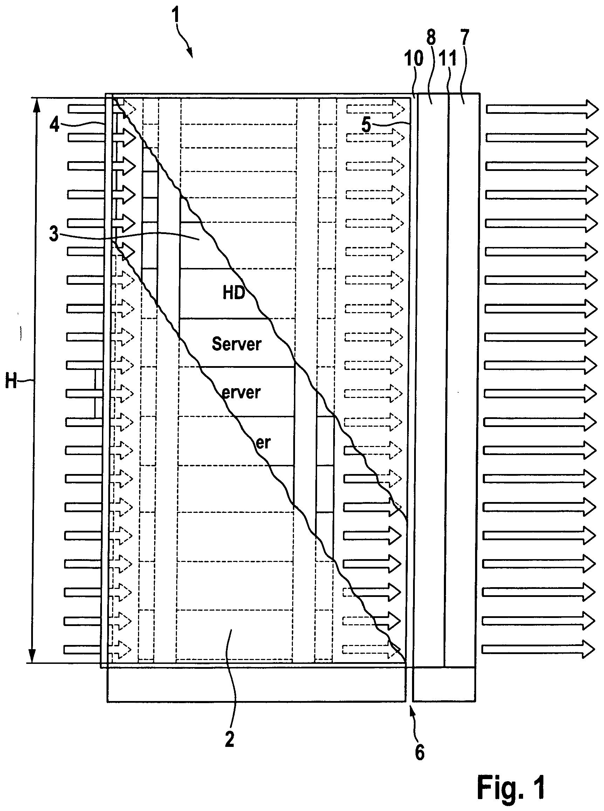

Figur 1 zeigt einen erfindungsgemäßen Schaltschrank 1, mit einem Schaltschrankinnenraum 2, in dem Wärme abgebende Komponenten 3 aufgenommen sind. In Luftströmungsrichtung (angedeutet durch die eingezeichneten Pfeile) an den Schaltschrank 1 rückwärtig angrenzend ist eine Kühlanordnung, umfassend eine Heatpipe-Anordnung 8 und einen Luft-Fluid-Wärmetauscher 7, angeordnet. Der Schaltschrank 1 weist frontseitig ein Türelement auf, das ein im Wesentlichen über seine gesamte Höhe perforiertes Türblatt aufweist, das einen Lufteinlass 4 bildet. An der die Rückseite des Schaltschrankinnenraums 2 bildenden vertikalen Seite 6 ist der Luftauslass 5 des Schaltschrankinnenraums 2 ausgebildet, welcher mit einer Lufteinlassseite der Heatpipe-Anordnung 8 zusammen fällt. Der Lufteinlass 4 und der Luftauslass 5 erstrecken sich im Wesentlichen über die gesamte Höhe H des Schaltschrankinnenraums 2, so dass sich im Schaltschrankinnenraum 2 ein im Wesentlichen horizontales Luftströmungsprofil ausbildet. Die Heatpipe-Anordnung 8 ist in Luftströmungsrichtung zwischen dem Luftauslass 5 und dem Luft-Fluid-Wärmetauscher 7 angeordnet, wobei der Luft-Fluid-Wärmetauscher 7 um eine horizontale Abmessung der Heatpipe-Anordnung 8, welche gerade dem Abstand der ersten vertikalen Montageseite 10 der Heatpipe-Anordnung 8 von der zweiten vertikalen Montageseite 11 der Heatpipe-Anordnung 8 entspricht, von der vertikalen Seite 6 des Schaltschrankinnenraums 2 beabstandet.

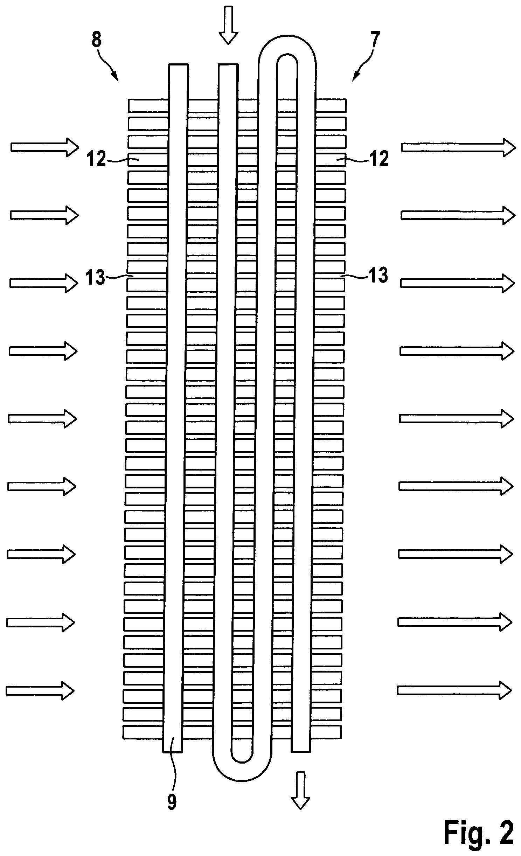

Figur 2 zeigt die bevorzugte Ausführungsform, bei welcher die Heatpipe-Anordnung 8 und der Luft-Fluid-Wärmetauscher 7 eine Einheit bilden. Die in der Darstellung gezeigte Heatpipe 9 repräsentiert eine Anordnung von Heatpipes, welche je nach Ausführungsform in unterschiedlicher Anzahl nebeneinander und hintereinander angeordnet sein können. Die Heatpipe 9 ist mit dem Kühlmittelkreislauf des Luft-Fluid-Wärmetauschers 7 über Lamellen 12 thermisch gekoppelt, um einen effektiven Wärmeaustausch zwischen der Heatpipe 9 und dem in dem Luft-Fluid-Wärmetauscher 7 geführten Fluid zu erreichen. Die Lamellen 12 begünstigen weiterhin den Wärmeaustausch zwischen der warmen Abluft des Schaltschrankinnenraums 2 und der Heatpipe-Anordnung 8. Des Weiteren sind die Lamellen 12 horizontal oder vertikal und parallel beabstandet zueinander angeordnet und bilden damit gerade sich horizontal in Luftströmungsrichtung erstreckende Durchlässe 13, um eine ungehinderte Durchströmung der Heatpipe-Anordnung 8 beziehungsweise des Luft-Fluid-Wärmetauschers 7 zu ermöglichen.

In Bereichen, wo in der Abbildung gemäß Figur 2 von links vergleichsweise warme Luft auf die Lamellen 12 trifft, wird entsprechend mehr Wärmeenergie auf die Heatpipe 9 übertragen, als in Bereichen, in welchen die die Heatpipe 9 anströmende Luft kühler ist. Dies hat zur Folge, dass in den wärmeren Bereichen der Heatpipe 9 vergleichsweise mehr Kühlmittel verdampfen kann, als in den Bereichen, wo die vergleichsweise kühlere Luft die Heatpipe 9 umströmt. In dem Bestreben des Gesamtsystems, ein Gleichgewicht herzustellen, wird in den kühleren Bereichen infolgedessen Kühlmittel kondensieren und dabei Wärme über die Wand der Heatpipe 9 an die jeweiligen Lamellen 12 übertragen, über welche die Wärmemenge an den Luft-Fluid-Wärmetauscher 7 weitergeleitet wird. Insgesamt wird durch die Vorschaltung der Heatpipe-Anordnung 8 somit eine gleichmäßigere Wärmebeaufschlagung des Luft-Fluid-Wärmetauschers 7 über seine gesamte Höhe erreicht. Dies hat wiederum die Vermeidung von Wärmenestern und damit eine Steigerung der Effizienz der Kühlanordnung zur Folge.

### Bezugszeichenliste

- 1: Schaltschrank
- 2: Schaltschrankinnenraum
- 3: Wärme abgebende Komponenten
- 4: Lufteinlass
- 5: Luftauslass
- 6: vertikale Seite des Schaltschrankinnenraums
- 7: Luft-Fluid-Wärmetauscher
- 8: Heatpipe-Anordnung
- 9: Heatpipe
- 10: Erste vertikale Montageseite
- 11: Zweite vertikale Montageseite
- 12: Lamelle
- 13: Durchlass
- H: Höhe des Schaltschrankinnenraums

## Patentansprüche

1. Anordnung aus einem Schaltschrank (1) und einem Kühlgerät zur Kühlung von in einem Innenraum (2) des Schaltschranks (1) aufgenommenen, Wärme abgebenden Komponenten (3), wobei das Kühlgerät aufweist:
- einen Lufteinlass (4) für Umgebungsluft in den Schaltschrankinnenraum (2);
- einen Luftauslass (5) für Warmluft aus dem Schaltschrankinnenraum (2) an einer vertikalen Seite (6) des Schaltschrankinnenraums (2), wobei der Luftauslass (5) eine vertikale Abmessung aufweist, die zumindest einem Teil einer Höhe (H) des Schaltschrankinnenraums (2) entspricht;
- einen Luft-Fluid-Wärmetauscher (7) mit einem Kühlmittelkreislauf, wobei durch den Luft-Fluid-Wärmetauscher (7) aus dem Schaltschrankinnenraum (2) über den Luftauslass (5) austretende Warmluft geführt ist, und wobei sich der Luft-Fluid-Wärmetauscher (7) zumindest anteilig über die vertikale Abmessung des Luftauslasses (5) erstreckt, und
- eine Heatpipe-Vorrichtung (8) mit mindestens einer sich zumindest über einen Teil der vertikalen Abmessung des Luftauslasses (5) erstreckenden Heatpipe (9), wobei die Heatpipe-Vorrichtung (8) in Luftströmungsrichtung zwischen dem Luftauslass (5) und dem Luft-Fluid-Wärmetauscher (7) angeordnet ist,
**dadurch gekennzeichnet, dass** sich die mindestens eine Heatpipe (9) der Heatpipe-Vorrichtung (8) und der Kühlmittelkreislauf des Luft-Fluid-Wärmetauschers (7) durch eine Mehrzahl Lamellen (12) hindurch erstrecken, sodass die Heatpipe-Vorrichtung (8) über die Lamellen (12) mit dem Luft-Fluid-Wärmetauscher (7) thermisch gekoppelt ist, wobei zwischen benachbarten Lamellen (12) ein Durchlass (13) für die aus dem Luftauslass (5) austretende Warmluft gebildet ist, wobei sich die Heatpipe-Vorrichtung (8) und der Kühlmittelkreislauf des Luft-Fluid-Wärmetauschers (7) zwischen einer lufteintretenden Seite und einer luftaustretenden Seite der Durchlässe (13) erstrecken.

2. Anordnung nach Anspruch 1, bei der der Luft-Fluid-Wärmetauscher (7) um eine horizontale Abmessung der Heatpipe-Vorrichtung (8) von der vertikalen Seite des Schaltschrankinnenraums (2) beabstandet ist.

3. Anordnung nach Anspruch 1 oder 2, bei der der Luft-Fluid-Wärmetauscher (7) und die Heatpipe-Vorrichtung (8) sich in vertikaler Richtung überlappend angeordnet sind, wobei die über den Luftauslass (5) austretende Warmluft zumindest anteilig erst durch die Heatpipe-Vorrichtung (8) und danach durch den Luft-Fluid-Wärmetauscher (7) geführt ist.

4. Anordnung nach einem der vorangegangen Ansprüche, bei der die Heatpipe-Vorrichtung (8) wie folgt ausgebildet ist:
a) mit einer ersten vertikalen Montageseite (10) angrenzend an die vertikale Seite (6) des Schaltschrankinnenraums (2) und den Luftauslass (5) anteilig oder vollständig überdeckend; und
b) mit einer zweiten, von der ersten Montageseite (10) parallel beabstandeten vertikalen Montageseite (11), an welche der Luft-Fluid-Wärmetauscher (7) angrenzt.

5. Anordnung nach einem der vorangegangenen Ansprüche, bei der der Schaltschrank (1) ein Rahmengestell mit vertikalen und horizontalen, eine Systemlochung aufweisenden Profilstreben aufweist, wobei der Luftauslass (5) von zwei vertikalen und zwei horizontalen, einen umlaufenden Rahmen bildenden Profilstreben abgegrenzt ist.

6. Anordnung nach einem der vorangegangen Ansprüche, bei der die Heatpipe-Vorrichtung (8) und der Luft-Fluid-Wärmetauscher (7) ein Luftleitsystem aufweisen, so dass sie optimal von der Warmluft horizontal durchströmt sind.

7. Anordnung nach einem der vorangegangen Ansprüche, bei der sich der Luftauslass (5), die Heatpipe-Vorrichtung (8) und der Luft-Fluid-Wärmetauscher (7) im Wesentlichen über die gesamte Höhe (H) des Schaltschrankinnenraums (2) erstrecken.

8. Anordnung nach einem der vorangegangen Ansprüche, bei der die Heatpipe-Vorrichtung (8) und der Luft-Fluid-Wärmetauscher (7) in einem Türelement, über das der Schaltschrankinnenraum (2) zugänglich ist, in horizontaler Richtung hintereinander aufgenommen sind, so dass im Servicefall die Heatpipe-Vorrichtung (8) über eine in Schließstellung des Türelements dem Schaltschrankinnenraum (2) zugewandte, erste Türblattseite zugänglich ist, und der Luft-Fluid-Wärmetauscher (7) über eine in Schließstellung des Türelements eine Außenseite des Schaltschranks (1) bildende, zweite Türblattseite zugänglich ist.

9. Anordnung nach einem der vorangegangen Ansprüche, bei der die Heatpipe-Vorrichtung (8) eine Mehrzahl Heatpipes (9) aufweist, von denen mindestens zwei in Luftströmungsrichtung durch die Heatpipe-Vorrichtung (8) hintereinander angeordnet sind, und/oder von denen mindestens zwei mit Bezug auf die Luftströmungsrichtung durch die Heatpipe-Vorrichtung (8) nebeneinander angeordnet sind.

10. Anordnung nach Anspruch 9, bei der mindestens zwei Heatpipes (9) an ihrem unteren Ende über ein Kältemittelsammelrohr miteinander verbunden sind.

11. Anordnung nach einem der vorangegangen Ansprüche, bei der die Lamellen (12) parallel zueinander und horizontal ausgerichtet sind.

## Claims

1. An arrangement having a switchgear cabinet (1) and a cooling device for cooling heat-emitting components (3) accommodated in an interior space (2) of the switchgear cabinet (1), the cooling device comprising:
- an air inlet (4) for ambient air entering the interior space (2) of the switchgear cabinet;
- an air outlet (5) for hot air exiting the interior space (2) of the switchgear cabinet on a vertical side (6) of the interior space (2) of the switchgear cabinet, the air outlet (5) having a vertical dimension corresponding to at least a part of a height (H) of the interior space (2) of the switchgear cabinet;
- an air-fluid heat exchanger (7) with a coolant circuit, wherein hot air exiting the interior space (2) of the switchgear cabinet via the air outlet (5) is guided through the air-fluid heat exchanger (7), and wherein the air-fluid heat exchanger (7) extends at least partially over the vertical dimension of the air outlet (5), and
- a heat pipe device (8) having at least one heat pipe (9) extending over at least a part of the vertical dimension of the air outlet (5), the heat pipe device (8) being arranged in the air flow direction between the air outlet (5) and the air-fluid heat exchanger (7),
**characterized in that** the at least one heat pipe (9) of the heat pipe device (8) and the coolant circuit of the air-fluid heat exchanger (7) extend through a plurality of lamellae (12) such that the heat pipe device (8) is thermally coupled to the air-fluid heat exchanger (7) via the lamellae (12), wherein a passage (13) for the hot air exiting from the air outlet (5) is formed between adjacent lamellae (12), wherein the heat pipe device (8) and the coolant circuit of the air-fluid heat exchanger (7) extend between an air entering side and an air exiting side of the passages (13).

2. The arrangement according to claim 1, wherein the air-fluid heat exchanger (7) is spaced apart from the vertical side of the interior space (2) of the switchgear cabinet by a horizontal dimension of the heat pipe device (8).

3. The arrangement according to claim 1 or 2, in which the air-fluid heat exchanger (7) and the heat pipe device (8) are arranged so as to overlap in the vertical direction, the hot air exiting via the air outlet (5) being guided at least partially first through the heat pipe device (8) and then through the air-fluid heat exchanger (7).

4. The arrangement according to one of the preceding claims, in which the heat pipe device (8) is formed as follows:
a) having a first vertical mounting side (10) adjacent the vertical side (6) of the interior space (2) of the switchgear cabinet and partially or completely covering said air outlet (5); and
b) having a second vertical mounting side (11) which is spaced apart parallel from the first mounting side (10) and to which the air-fluid heat exchanger (7) adjoins.

5. The arrangement according to one of the preceding claims, the switchgear cabinet (1) comprising a frame rack with vertical and horizontal profiles having a system perforation, the air outlet (5) being delimited by two vertical and two horizontal profiles forming a circumferential frame.

6. The arrangement according to one of the preceding claims, in which the heat pipe device (8) and the air-fluid heat exchanger (7) have an air-guiding system so that the warm air flows optimally horizontally through them.

7. The arrangement according to one of the preceding claims, wherein the air outlet (5), the heat pipe device (8) and the air-fluid heat exchanger (7) extend substantially over the entire height (H) of the interior space (2) of the switchgear cabinet.

8. The arrangement according to one of the preceding claims, in which the heat pipe device (8) and the air-fluid heat exchanger (7) are accommodated one behind the other in the horizontal direction in a door element via which the interior space (2) of the switchgear cabinet is accessible, so that, in the event of servicing, the heat pipe device (8) is accessible via a first door leaf side facing the interior space (2) of the switchgear cabinet in the closed position of the door element, and the air-fluid heat exchanger (7) is accessible via a second door leaf side forming an outer side of the switchgear cabinet (1) in the closed position of the door element.

9. The arrangement according to one of the preceding claims, wherein the heat pipe device (8) comprises a plurality of heat pipes (9), at least two of which are arranged one behind the other in the air flow direction through the heat pipe device (8), and/or at least two of which are arranged side by side with respect to the air flow direction through the heat pipe device (8).

10. The arrangement according to claim 9, in which at least two heat pipes (9) are connected to one another at their lower end via a refrigerant collecting pipe.

11. The arrangement according to one of the preceding claims, in which the lamellae (12) are aligned parallel to one another and horizontally.

## Revendications

1. Ensemble composé d'une armoire de commande (1) et d'un appareil de refroidissement destiné au refroidissement de composants (3) reçus dans un espace intérieur (2) de l'armoire de commande (1) et dégageant de la chaleur, l'appareil de refroidissement comportant :
- une entrée d'air (4) pour de l'air ambiant en direction de l'espace intérieur (2) de l'armoire de commande ;
- une sortie d'air (5) pour de l'air chaud en provenance de l'espace intérieur (2) de l'armoire de commande sur un côté (6) vertical de l'espace intérieur (2) de l'armoire de commande, la sortie d'air (5) présentant une dimension verticale qui correspond au moins à une partie de la hauteur (H) de l'espace intérieur (2) de l'armoire de commande ;
- un échangeur de chaleur air-fluide (7) avec un circuit de réfrigérant, l'air chaud sortant de l'espace intérieur (2) de l'armoire de commande via la sortie d'air (5) étant conduit à travers l'échangeur de chaleur air-fluide (7), et l'échangeur de chaleur air-fluide (7) s'étendant au moins partiellement sur la dimension verticale de la sortie d'air (5), et
- un dispositif à caloduc (8) avec au moins un caloduc (9) s'étendant au moins sur une partie de la dimension verticale de la sortie d'air (5), le dispositif à caloduc (8) étant disposé, dans le sens d'écoulement de l'air, entre la sortie d'air (5) et l'échangeur de chaleur air-fluide (7),
**caractérisé en ce que** le caloduc (9), au moins au nombre de un, du dispositif à caloduc (8) et le circuit de réfrigérant de l'échangeur de chaleur air-fluide (7) s'étendent à travers une pluralité de lamelles (12) de telle sorte que le dispositif à caloduc (8) est couplé thermiquement à l'échangeur de chaleur air-fluide (7) par le biais des lamelles (12), un passage (13) pour l'air chaud sortant de la sortie d'air (5) étant formé entre des lamelles (12) voisines, le dispositif à caloduc (8) et le circuit de réfrigérant de l'échangeur de chaleur air-fluide (7) s'étendant entre un côté d'entrée d'air et un côté de sortie d'air des passages (13).

2. Ensemble selon la revendication 1, dans lequel l'échangeur de chaleur air-fluide (7) présente par rapport au côté vertical de l'espace intérieur (2) de l'armoire de commande un espacement correspondant à une dimension horizontale du dispositif à caloduc (8).

3. Ensemble selon la revendication 1 ou 2, dans lequel l'échangeur de chaleur air-fluide (7) et le dispositif à caloduc (8) sont disposés en chevauchement dans la direction verticale, l'air chaud sortant via la sortie d'air (5) étant conduit au moins partiellement d'abord à travers le dispositif à caloduc (8) et ensuite à travers l'échangeur de chaleur air-fluide (7).

4. Ensemble selon l'une des revendications précédentes, dans lequel le dispositif à caloduc (8) est constitué comme suit :
a) avec un premier côté de montage (10) vertical qui est contigu au côté (6) vertical de l'espace intérieur (2) de l'armoire de commande et qui recouvre partiellement ou complètement la sortie d'air (5) ; et
b) avec un deuxième côté de montage (11) vertical, espacé parallèlement du premier côté de montage (10), auquel l'échangeur de chaleur air-fluide (7) est contigu.

5. Ensemble selon l'une des revendications précédentes, dans lequel l'armoire de commande (1) comporte un bâti de cadre avec des barrettes profilées verticales et horizontales présentant un système de perforations, la sortie d'air (5) étant délimitée par deux barrettes profilées verticales et deux barrettes profilées horizontales formant un cadre périphérique.

6. Ensemble selon l'une des revendications précédentes, dans lequel le dispositif à caloduc (8) et l'échangeur de chaleur air-fluide (7) comportent un système de guidage d'air de telle sorte qu'ils sont parcourus horizontalement de façon optimale par l'air chaud.

7. Ensemble selon l'une des revendications précédentes, dans lequel la sortie d'air (5), le dispositif à caloduc (8) et l'échangeur de chaleur air-fluide (7) s'étendent essentiellement sur toute la hauteur (H) de l'espace intérieur (2) de l'armoire de commande.

8. Ensemble selon l'une des revendications précédentes, dans lequel le dispositif à caloduc (8) et l'échangeur de chaleur air-fluide (7) sont, l'un derrière l'autre dans la direction horizontale, reçus dans un élément de porte par le biais duquel l'espace intérieur (2) de l'armoire de commande est accessible de telle sorte que, en cas d'intervention de service, le dispositif à caloduc (8) est accessible par le biais d'un premier côté de panneau de porte tourné vers l'espace intérieur (2) de l'armoire de commande dans la position de fermeture de l'élément de porte, et l'échangeur de chaleur air-fluide (7) est accessible par le biais d'un deuxième côté de panneau de porte formant, dans la position de fermeture de l'élément de porte, un côté extérieur de l'armoire de commande (1).

9. Ensemble selon l'une des revendications précédentes, dans lequel le dispositif à caloduc (8) comporte une pluralité de caloducs (9) dont au moins deux sont disposés l'un derrière l'autre dans la direction d'écoulement de l'air à travers le dispositif à caloduc (8), et/ou dont au moins deux sont disposés de façon juxtaposée par rapport à la direction d'écoulement de l'air à travers le dispositif à caloduc (8).

10. Ensemble selon la revendication 9, dans lequel au moins deux caloducs (9) sont, à leur extrémité inférieure, raccordés l'un à l'autre par le biais d'un collecteur tubulaire de réfrigérant.

11. Ensemble selon l'une des revendications précédentes, dans lequel les lamelles (12) sont orientées parallèlement entre elles et horizontalement.
